# EUROPEAN PATENT APPLICATION

(11) **EP 2 581 995 A2**
(43) Date of publication of application: **17.04.2013**
(21) Application number: 12187599.1
(22) Date of filing: 08.10.2012
(51) Int. Cl.: H01R 43/02

(54) **Connector**

(30) Priority: 13.10.2011 JP 2011225953
(71) Applicant: Tyco Electronics Japan G.K., Takatsu-ku Kawasaki-shi Kanagawa 213-8535 (JP)
(72) Inventor: Terajima, Keita, Kawasaki, Kanagawa 213-8535 (JP)
(74) Representative: Johnstone, Douglas Ian

(57) **Abstract**

A connector (1) includes an insulation board (11), a conductor pattern (15), a rod-shaped member (16) and solder (17). The insulation board (11) is provided with a through hole (11h) penetrating from a top face (11a) to a bottom face (11b). The conductor pattern (15) covers an internal wall of the through hole (11h). The rod-shaped member (16) includes a first end (16b) protruding from the bottom face (11b) and a second end (16a) inside the through hole (11h). The solder (17) closes a gap between the internal wall of the through hole (11h) and the rod-shaped member (16) and covers the second end (16a) of the rod-shaped member (16).

## Description

The present invention relates to a connector to carry out an electrical connection in an apparatus having the gastightness.

Such a connector, which carries out an electrical connection between an inside and an outside of a partition wall of a decompressed or evacuated vacuum chamber is known. The known connector has a board which is attached at a position to close an opening of the partition wall. The board has a through hole which penetrates from a top surface to a bottom surface thereof and the inside of which is filled with solder.

A configuration including a through hole filled with solder is disclosed, for example in Japanese Patent Publication JP 2009-99779A which illustrates a printed circuit board having a through hole. A lead of a mounted component goes through the through hole and the through hole is filled with solder. In the printed circuit board, in order to accelerate cooling speed upon soldering, an area of conductive land containing the through hole is enlarged to increase heat radiation efficiency. In this way an attempt is made to reduce cracking (shrinkage cavity) produced on a solder surface as the cooling speed decreases.

In the above-described printed circuit board, the lead penetrates the solder on both the top surface and the bottom surface. Accordingly an interface between the lead and the solder is exposed on both the top surface and the bottom surface. Thus, when an atmospheric pressure difference exists between the top surface and the bottom surface, a gas may leak along an interface between the lead and the solder.

Alternatively a configuration in which only solder is arranged in the through hole is conceivable. However, in this case, if a reflow soldering process, using a solder paste, is applied in volume or mass production, a volatile component of the solder paste filling the through hole is lost and the volume of the solder reduces remarkably. As a result, the solder inside the through hole becomes thin and may be broken by a filling failure or a difference in pressure between the top and bottom surfaces of the connector.

The present invention has been made in view of the above circumstances and provides a connector having improved gastightness.

According to an aspect of the present invention, a connector includes: an insulation board that includes a top surface and a bottom surface, and a through hole penetrating from the top surface to the bottom surface; a conductor pattern that covers an internal wall of the through hole; a rod-shaped member that extends in the through hole in a direction intersecting the top surface, and includes a first end protruding from the bottom surface and a second end opposite to the first end within the through hole; and solder that closes a gap between the internal wall of the through hole and the rod-shaped member, and covers the second end of the rod-shaped member.

With the connector according to the present invention, the rod-shaped member is inserted into the through hole and the solder closes the gap remained in the through hole. The amount of solder required for closing the through hole decreases by the volume occupied by the rod-shaped member in the through hole. Thus, considering the filling materials as a whole in the through hole, the amount of decrease in volume, when solder paste becomes solder during the reflow process, is less than that in a case where the rod-shaped member is not present in the through hole. Accordingly, the decrease of thickness of the solder in the through hole is reduced and thus the gastightness is increased. Furthermore, the second end of the rod-shaped member is inside the through hole and covered with the solder. In other words, the interface between the rod-shaped member and the solder is not exposed outside on the top face of the insulation board. For this reason, a leak of gas is prevented through an interface between the rod-shaped member and the solder and thus the gastightness is further enhanced.

In the connector according to a preferred aspect of the present invention, the rod-shaped member is made of a metal material.

A metal material has a small amount of decreasing volume by heating in reflow soldering. In addition, solder adheres easily to a metal material. For these reasons, escaping of molten solder from an interface between the rod-shaped member and the through hole on the top face of the insulation board is prevented.

In the connector according to the aspect of the present invention, it is preferable that the solder surrounds the entire periphery of the rod-shaped member.

The rod-shaped member is coupled with the through hole all around so that the gastightness is further enhanced.

As described above, according to the present invention, a connector having an enhanced gastightness is obtained.

In the accompanying drawings:
FIG. 1 is a perspective view illustrating a top face of a connector according to a first embodiment of the present invention;
FIG. 2 is a perspective view illustrating a bottom face of the connector according to the first embodiment of the present invention;
FIG. 3 is a sectional view illustrating a cross section of the connector illustrated in FIG. 1 taken along line 3-3;
FIG. 4 is a perspective view illustrating a first step for producing the connector illustrated in FIGS. 1-3;
FIG. 5 is a sectional view illustrating a second step for producing the connector illustrated in FIGS. 1-3;
FIG. 6 is a sectional view illustrating a third step for producing the connector illustrated in FIGS. 1-3;
FIG. 7 is a sectional view illustrating a comparative example in which a rod-shaped member is not included;
FIG. 8 is an outline of configuration illustrating an application example of the connector 1 illustrated in FIGS. 1-3; and
FIG. 9 is a perspective view illustrating a portion of a connector according to a second embodiment.

Exemplary embodiments according to the present invention will be described with reference to the drawings.

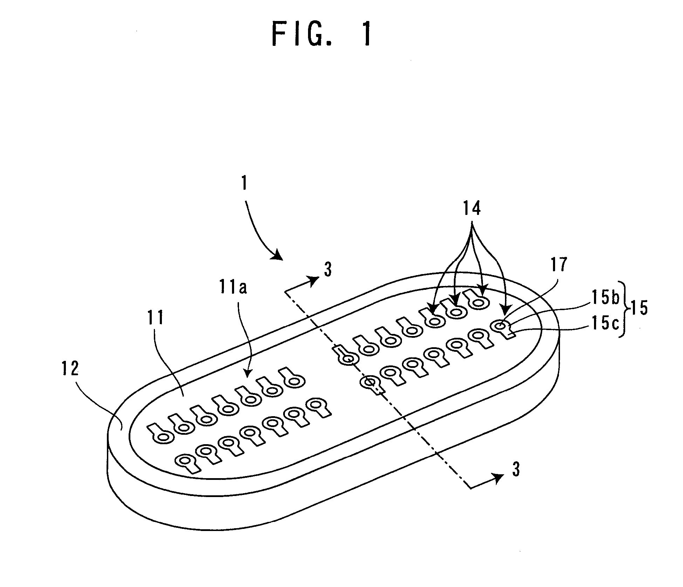

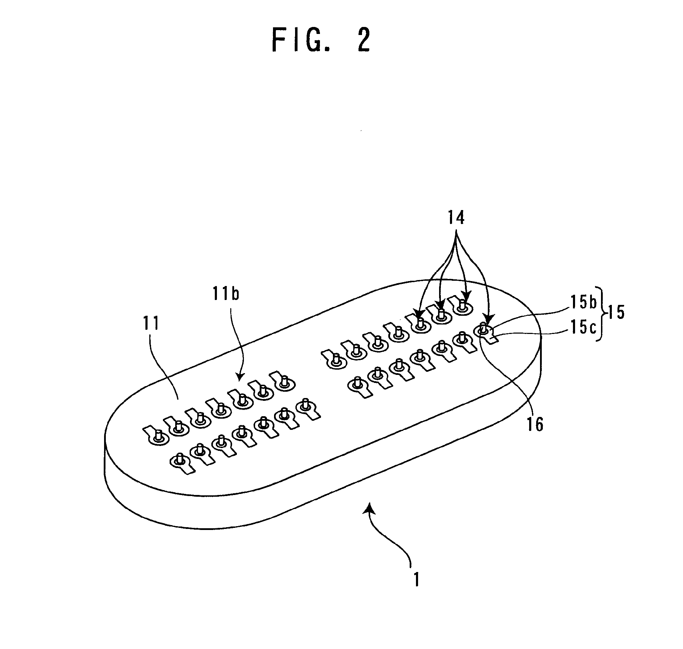

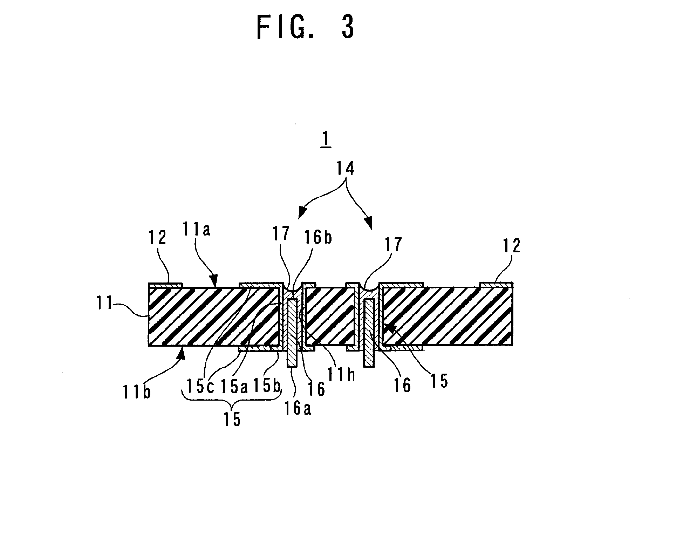

FIGS. 1 and 2 are perspective views illustrating a connector which is a first embodiment according to the present invention. FIG. 1 illustrates a top face of the connector 1, and FIG. 2 illustrates a bottom face of the connector 1. In addition, FIG. 3 is a sectional view illustrating a cross-section of the connector 1 illustrated in FIG. 1 taken along line 3-3.

The connector 1 illustrated in FIGS. 1-3 is a tabular component. The connector 1 is attached to a position where the connector 1 covers an opening of a partition wall which will be described later, covers the opening and serves for an electrical connection between an inside and an outside of the partition wall via the opening. The connector 1 is attached while a top face 11a thereof, illustrated in FIG. 1, faces the partition wall. The connector 1 includes an insulation board 11 and electrical connection sections 14.

The insulation board 11 is a tabular portion made of an insulating material. The material of the insulative board 11 is, for example, glass-containing epoxy or ceramic. The insulation board 11 includes the top face 11a facing the partition wall and a bottom face 11b which is a face opposite to the top face. The insulation board 11 includes through holes 11h (see FIG. 3) penetrating from the top face 11a to the bottom face 11b of the insulation board 11. In addition, a strip-shaped sealing metal plating pattern 12 is provided along a periphery of the top face 11a on the top face 11a of the insulation board 11. The strip-shaped sealing metal plating pattern 12 is formed by plating with metal.

The connector 1 illustrated in FIG. 1 is a connector including 28 electrode positions, and 28 electrical connection section 14 positions which are arranged in the insulation board 11 of the connector 1. The strip-shaped sealing metal plating pattern 12 surrounds the 28 electrical connection section 14 positions which are exposed on the top face 11a.

As illustrated in FIG. 3, each of the electrical connection sections 14 includes, a connecting conductor pattern 15, a rod-shaped member 16 and solder 17.

Each of the connecting conductor patterns 15 is formed by plating with metal, and includes an inner wall section 15a, edge sections 15b and contact sections 15c. Each of the inner wall sections 15a covers an internal wall of each of the through holes 11h. The edge sections 15b extend from or continue to the inner wall section 15a, and spread in an annular ring shape at opening edge portions of the through hole 11h. The contact sections 15c project from rims of the edge sections 15b on both of the top face 11a and the bottom face 11b of the insulation board 11.

Each of the rod-shaped members 16 has a bar shape or is in the form of a cylindrical column, and is formed of metal having a melting temperature higher than that of the solder 17. The rod-shaped members 16 extend or are positioned in the through holes 11h in a direction intersecting the top face 11a of the insulation board 11. Specifically, each of the through holes 11h extends at an angle approximately perpendicular to the top face 11a of the insulation board 11, and the rod-shaped members 16 extend approximately parallel to the through holes 11h, that is, approximately perpendicularly to the top face 11a. A first end 16a of each of the rod-shaped members 16 protrudes beyond the bottom face 11b. In addition, a second end 16b of each rod-shaped member 16, opposite to the first end 16a, is situated inside a respective through hole 11h. In other words, a portion of each of the rod-shaped member 16 is situated in a respective through hole 11h, and a remaining portion thereof lies outside of the respective through hole 11h. More specifically, each rod-shaped member 16 enters into the respective through hole 11h by more than a half of the thickness of the insulation board 11 (that is, a length of the through hole 11h).

Diameters of the rod-shaped members 16 are smaller than internal diameters of the through holes 11h of the connecting conductor patterns 15. The rod-shaped members 16 are spaced apart from the internal walls of the through holes 11h, and do not make contact with the internal walls. More specifically, the rod-shaped members 16 are arranged radially approximately at centers of the through holes 11h.

The solder 17 is a metal alloy predominantly composed of tin. The solder 17 is formed through a process in which a solder paste is heated in a reflow soldering process. The solder 17 closes a gap between the internal wall of each of the through holes 11h and each of the rod-shaped members 16. More specifically, a gap is provided between each of the connecting conductor patterns 15 and the respective rod-shaped member 16. As described above, since the rod-shaped members 16 do not make contact with the internal walls of the through holes 11h, the solder 17 surrounds entire periphery of each of the rod-shaped members 16. In other words, the solder 17 exists all around each of the rod-shaped members 16 between each of the rod-shaped members 16 and each of the internal walls of the through holes 11h. The solder 17 covers the second ends 16b of the rod-shaped members 16 inside the through holes 11h. A portion of each through hole 11h not occupied by the respective rod-shaped members 16 is filled with solder 17 only.

The solder 17 is fused with the connecting conductor patterns 15 covering the internal walls of the through holes 11h, and also fused with the rod-shaped members 16. Thus, each of the electrical connection sections 14 has a structure in which the through hole 11h is closed in a gastight manner by the connecting conductor pattern 15, the rod-shaped member 16 and the solder 17.

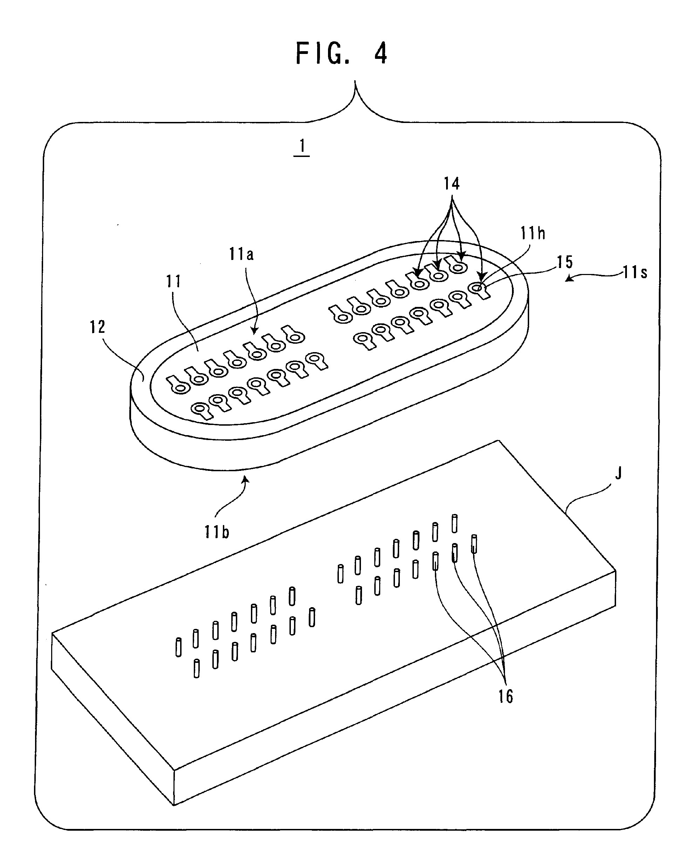

FIGS. 4-6 are views illustrating steps for producing the connector 1 illustrated in FIGS. 1-3. FIG. 4 is a perspective view illustrating a first step for producing the connector 1.

In the first step, firstly, the through holes 11h are formed in the insulation board 11, and the strip-shaped sealing metal plating pattern 12 and the connection conductor patterns 15 are formed by plating with metal. Next, a tabular jig J is prepared, and the rod-shaped members 16 are arranged on the jig J. The jig J is not melted or deformed and transformed at a molten solder temperature, and is formed of a material resistant to being adhered to with molten solder (the degree of wetting or wettability is low). The material of the jig J, for example, may be carbon. The jig J is provided with openings having an arrangement similar to that of the through holes 11h in the connector 1, into each of which opening a portion of one of the rod-shaped members 16 is inserted.

Next, the insulation board 11, on/in which the strip-shaped sealing metal plating pattern 12 and the connecting conductor patterns 15 have been formed, is placed on the jig J on which the rod-shaped members 16 have been arranged. At this stage, the bottom face 11b of the insulation board 11 faces the jig J.

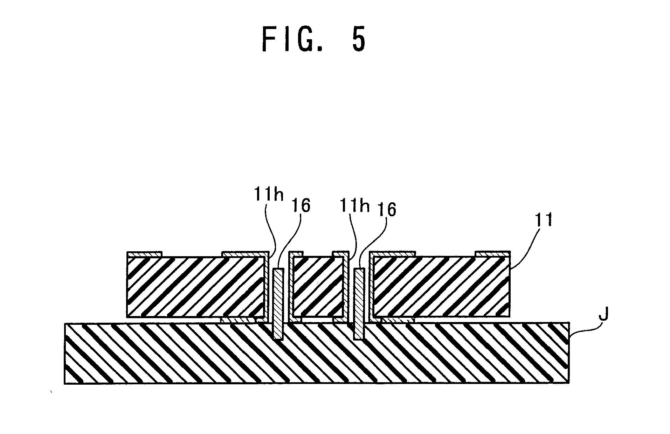

FIG. 5 is a sectional view illustrating a second step for producing the connector 1.

In the second step, the insulation board 11 is placed on the jig J such that the rod-shaped members 16 are inserted into the through holes 11h of the insulation board 11. The insulation board 11 is positioned relative to the jig J such that the rod-shaped members 16 are positioned at centers of the through holes 11h.

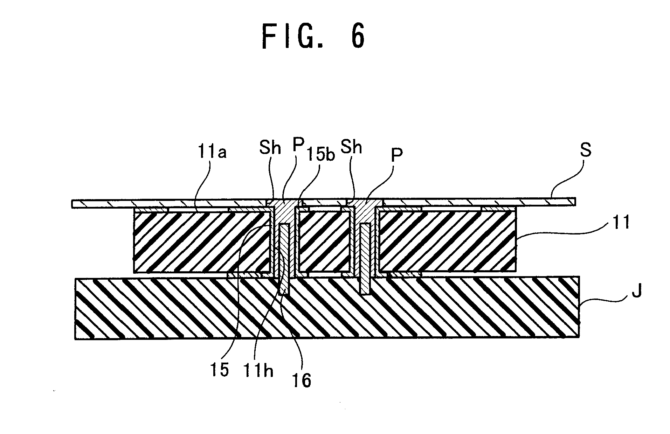

FIG. 6 is a sectional view illustrating a third step for producing the connector 1.

In the third step, the through holes 11h of the insulation board 11 are filled with solder paste P. Specifically, firstly, a pattern (stencil) S with openings Sh having an arrangement similar to that of the through holes 11h is placed on the top face 11a of the insulation board 11. The openings Sh of the stencil S are larger than the diameter of the through holes 11h and each the openings Sh has a size of the extent of the edge sections 15b of the connecting conductor patterns 15 (see FIG. 1). Next, by using a squeegee or squeezing device made of, for example, rubber, the solder paste P is squeezed into the through holes 11h from the openings Sh of the stencil S. Through this step, the through holes 11h are filled with the solder paste P. The rod-shaped members 16 are positioned inside the through holes 11h, and the solder paste P fills between the internal walls of the through holes 11h and the rod-shaped members 16 while surrounding the entire periphery of the rod-shaped members 16. In addition, the solder paste P covers the second ends 16b of the rod-shaped members 16 to close the through holes 11h.

Next, the stencil S is removed, and a reflow soldering process is applied to heat the solder paste while the insulation board 11 remains placed on the jig J. The reflow soldering process has higher manufacturability, compared with a solder flow process in which a board is dipped in molten solder. The solder paste P is heated and so metal components thereof are melted and fuse with the connecting conductor patterns 15 covering the internal walls of the through holes 11h. As a result, the connector 1 illustrated in FIG. 3 is completed.

The solder paste used in the reflow soldering includes volatile components which evaporate and are lost at the temperature of the reflow soldering process. For example, more than a half of the volume of the solder paste is made up by the volatile components. For this reason, the volume of the solder 17 (see FIG. 3) is reduced so as to be less than a half, compared with the solder paste P (see FIG. 6). As a result of this, as illustrated in FIG. 3, the distances (height) by which the solder 17 fills each through hole 11h is less than the whole length of the through hole 11h.

However, in the connector 1 according to the present embodiment, the rod-shaped members 16, which do not include volatile components, are arranged inside the through holes 11h. The volume of each rod-shaped member 16 is not reduced by being heated. The amount of the solder paste P (see FIG. 6) in each of the through holes 11h may be reduced by a portion of the volume occupied by each of the rod-shaped members 16 in each of the through holes 11h. For this reason, the amount of volume reduced when the solder paste P becomes the solder 17, through the reflow soldering process, is reduced.

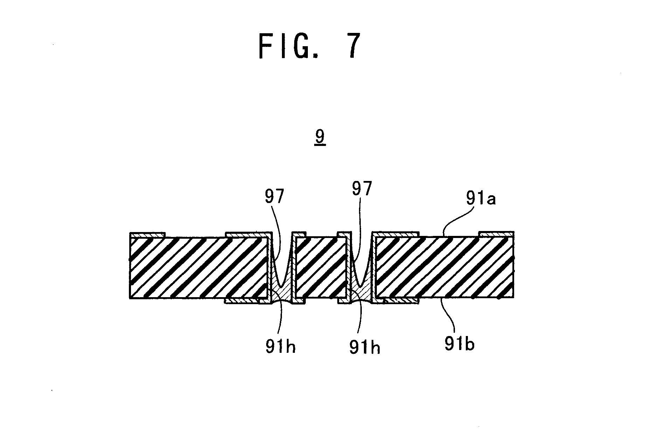

FIG. 7 is a sectional view illustrating a comparative example in which a rod-shaped member is not arranged in each through hole 11h.

In a connector 9 of the comparative example illustrated in FIG. 7, rod-shaped members are not included, and only solder 97 exists in the through holes 91h. For this reason, in the connector 9, the amount of volume reduction is large when the solder paste becomes the solder 97 through a reflow soldering process. Thus, the distances or extent to which the solder fills the through holes 91h become small. In the connector 9 of the comparative example, when a pressure difference is applied to a top face 91a and a bottom face 91b of the connector 9, the solder 97 may be damaged, and thus there is a possibility of gastightness being decreased or lost.

In the connector 1 according to the present embodiment illustrated in FIG. 3, the amount of reduced volume when the solder paste P becomes the solder 17, through a reflow soldering process, is reduced compared with the comparative example illustrated in FIG. 7. In the connector 1, since the distance by which each of the through holes 11h is filled is large, damage of the solder 17 is prevented, even in an environment where there is a pressure difference between the top and bottom surfaces. Accordingly, the gastightness of the electrical connection section 14 is high. In addition, the solder 17 around the rod-shaped members 16 exists in narrow gaps between the internal walls of the through holes 11h and the rod-shaped members 16 and can also be assumed to be rigid. The rod-shaped members 16 can also be assumed to be rigid. Also for this reason, the gastightness is enhanced.

Further, in the connector 1 according to the present embodiment, the second ends 16b of the rod-shaped members 16 are inside the through holes 11h, and covered by the solder 17. In other words, the interface between each of the rod-shaped members 16 and the surrounding solder 17 is not exposed on the top face 11a of the insulation board. In a case in which a rod-shaped member penetrates a through hole, a leak of a small quantity of gas through the interface between each rod-shaped member 16 and the surrounding solder 17 could occur. With the connector according to the invention this will not occur. In addition, any leakage of gas resulting from a crack and the like produced between each of the rod-shaped members 16 and the surrounding solder 17, due to an external force applied to the rod-shaped member 16 and/or a difference of thermal coefficients of the expansion will be decreased. Thus, the gastightness of the connector 1 according to the present embodiment is further improved. In the connector 1 according to the present embodiment, since the rod-shaped members 16 are made of metal, they easily adhere with solder in a reflow soldering process. For this reason, the escape of solder from the second ends 16b of the rod-shaped members 16 is effectively prevented. The interface between each rod-shaped member 16 and the solder 17, at top face 11a of the insulation board 11 is good.

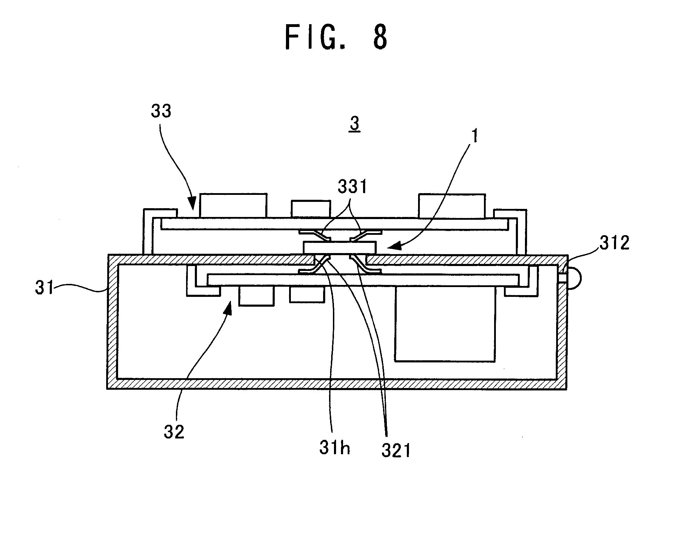

FIG. 8 is an outline of configuration illustrating an application example of the connector 1 illustrated in FIGS. 1-3 and an attachment structure.

An apparatus 3 illustrated in FIG. 8 is a chamber apparatus which operates in an environment in which pressure and composition are adjusted. Specifically, the apparatus 3 includes a partition wall 31, an internal circuit board 32, an external circuit board 33 and the connector 1 illustrated in FIGS. 1-3. In FIG. 8, the connector 1 is arranged with the top face 11a illustrated in FIG. 1 facing downward.

The partition wall 31 is a container which partitions off an inner space from an outer space. The internal circuit board 32 is arranged inside the partition wall 31. An electronic component and a constitutional device which operate in a decompressed or compressed environment are contained inside the partition wall 31. The partition wall 31 includes a wiring opening 31h for electrical wiring. The connector 1 is larger than the wiring opening 31h, and is attached at a position covering the wiring opening 31h to close the wiring opening 31h. Specifically, the insulation board 11 (see FIG. 1) of the connector 1 closes the wiring opening 31h. In addition, the connector 1 serves for an electrical connection through the wiring opening 31h between an inside and an outside of the partition wall 31. Solder as a sealing member seals between the strip-shaped sealing metal plating pattern 12 provided on the insulation board 11 of the connector 1 (see FIG. 1) and the partition wall 31.

The external circuit board 33 is arranged outside the partition wall 31, supplies electrical power to the internal circuit board 32 and also controls the internal circuit board 32. The connector 1 is a component for connecting the internal circuit board 32 and the external circuit board 33. The internal circuit board 32 and the external circuit board 33 respectively include contacts 321 and 331 for making contact with the connector 1. The contacts 321 and 331 make contact with the connection sections 15c of the connecting conductor patterns 15 (see FIGS. 1 and 2) of the connector 1. The internal circuit board 32 and the external circuit board 33 are electrically connected with each other via the electrical connection sections 14 (see FIG. 3) of the connector 1.

The partition wall 31 becomes gastight by being attached to the connector 1. Air or gas is discharged or injected through an exhaust-intake opening 312, and thus pressure in a space enclosed by the partition wall 31 becomes decreased or increased relative to pressure outside the wall 31. The electronic component and the constitutional device of the internal circuit board 32 operates under such increased or decreased pressure.

The connector 1 according to the present embodiment has the high gastightness as described above, and maintains the gastightness of the inside of the partition wall 31 over a long period.

Next, a second embodiment according to the present invention will be described. In the following description of the second embodiment, elements same as those in the embodiment described above are respectively provided with the same reference numerals, and differences from the above-described embodiment will be described.

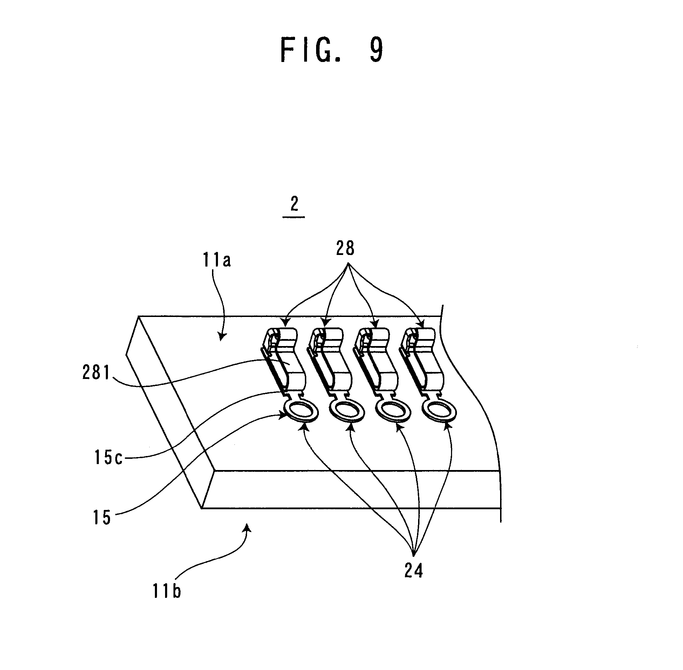

FIG. 9 is a perspective view illustrating a portion of a connector according to the second embodiment.

A connector 2 illustrated in FIG. 9 is different from the connector 1 according to the first embodiment in that the connector 2 includes contact members 28 which are provided on the electrical connection sections 24. The connector 2 is similar to the connector 1 in other aspects. FIG. 9 illustrates a portion corresponding to four electrical connection sections 24 of the connector 2.

The contact members 28 of the connector 2 are arranged on both of the top face 11a and the bottom face 11b of the insulation board 11. The contact members 28 are connected by soldering to the contact sections 15c of the connecting conductor patterns 15. The contact members 28 are members formed by stamping and forming a conductive metal plate, and include elastic connection sections 281 which elastically make contact with another circuit board.

The connector 2 according to the present embodiment is used when the internal circuit board 32 and the external circuit board 33 of the apparatus 3 illustrated in FIG. 8 do not include the contacts 321 and 331. The connector 2 is directly connected to conductor patterns (not illustrated) of the internal circuit board 32 and the external circuit board 33 of the apparatus 3 illustrated in FIG. 8.

Incidentally, the connector 2, in which the contact members 28 are arranged on both of the top face 11a and the bottom face 11b of the insulation board 11, is described in the second embodiment described above. However, the present invention is not limited to this arrangement. For example, the contact members may be arranged on only one face of the insulation board.

In addition, the insulation board 11 in the embodiments described above has an oval shape or rounded ends. However, the present invention is not limited to this shape. The shape of the insulation board may, for example be rectangular.

In addition, the strip-shaped sealing metal plating pattern 12 in the embodiments described above is arranged on the periphery of the top face 11a of the insulation board 11. However, the strip-shaped sealing metal pattern may extend continuously to a side face of the insulation board. In addition, the strip-shaped sealing metal plating pattern may be arranged on the bottom face of the insulation board and the connector may be arranged with the bottom face facing the partition wall.

In addition, in the embodiments describe above, the cylindrical column made of metal is described as an example of the rod-shaped member according to the present invention. However, the present invention is not limited to this form of rod-shaped member. The rod-shaped member may be a resin material the surface of which is plated, and/or may be prism-shaped.

Further, the solder 17 in the embodiments described above surrounds the entire periphery of each rod-shaped member 16. However, the present invention is not limited to this arrangement. A portion of each of the rod-shaped members may make contact with each of the conductive patters of the through holes.

Furthermore, 28 positions of the electrical contact sections 14 are provided in the embodiments described above. However, the present invention is not limited to this arrangement. The number of the electrical contact sections may be other than 28. In addition, regarding the shape of the electrical contact sections, the electrical contact sections may include, for example, further extended portions on the top face and the bottom face.

## Claims

1. A connector (1) comprising:
an insulation board (11) that includes a top surface (11a) and a bottom surface (11b), and a through hole (11h) penetrating from the top surface (11a) to the bottom surface (11b);
a conductor pattern (15) that covers an internal wall of the through hole (11h);
a rod-shaped member (16) that extends in the through hole (11h) in a direction intersecting the top surface (11a), and includes a first end (16a) protruding from the bottom surface (11b) and a second end (16b) opposite to the first end (16a) within the through hole (11h); and
solder (17) that closes a gap between the internal wall of the through hole (11h) and the rod-shaped member (16), and covers the second end (16b) of the rod-shaped member (16).

2. The connector (1) according to claim 1, wherein the rod-shaped member (16) is made of a metal material.

3. The connector (1) according to claim 1 or 2, wherein the solder (17) surrounds an entire periphery of the rod-shaped member (16).
